# EUROPEAN PATENT APPLICATION

(11) **EP 2 309 829 A1**
(43) Date of publication of application: **13.04.2011**
(21) Application number: 09171164.8
(22) Date of filing: 24.09.2009
(51) Int. Cl.: H05K 1/14, H05K 3/36, H05K 3/46, G11B 7/09

(54) **Multilayer circuit board**

(71) Applicant: Harman Becker Automotive Systems GmbH, 76307 Karlsbad (DE)
(72) Inventor: Suzuki, Tsuneo, 78087 Mönchweiler (DE); Dupper, Rolf, 78050 VS-Villingen (DE)
(74) Representative: Bickel, Michael

(57) **Abstract**

The invention relates to a multilayer circuit board. The board comprises a flat first dielectric layer having a first side and a second side, and a flat second dielectric layer having a first side and a second side. The first side of the second dielectric layer faces towards the first side of the first dielectric layer. On the first side of the first dielectric layer a first conductor path is arranged. Accordingly, on the first side of the second dielectric layer a second conductor path is arranged. Between the first dielectric layer and the second dielectric layer a soldered joint is arranged which electrically connects the first conductor path and the second conductor path. The first dielectric layer is formed continuously in the area of the soldered joint.

## Description

### FIELD OF TECHNOLOGY

The invention relates to multilayer circuit boards and to a method for producing a multilayer circuit board.

### BACKGROUND

Common multilayer circuit boards comprise two or more electric layers.

However, there is a need for an improved multilayer circuit board in which, in the area of an electrical connection between two or more interior electric layers, no space is wasted in at least one of the exterior electric layers, and/or in which a weight increase caused by forming the electrical connection is less than the weight increase would be if the electrical connection was formed by use of a via extending through the multilayer circuit as a whole. Further, there is a need for a method for producing such an improved multilayer circuit board.

### SUMMARY

According to one aspect, a multilayer circuit board may comprise a flat first dielectric layer with a first side and with a second side, and a flat second dielectric layer with a first side and a second side. The first side of the second dielectric layer may face towards the first side of the first dielectric layer. A first conductor path may be arranged on the first side of the first dielectric layer, a second conductor path on the first side of the second dielectric layer. Between the first dielectric layer and the second dielectric layer a soldered joint may be arranged which electrically connects the first conductor path and the second conductor path. In the area of the soldered joint the first dielectric layer may be formed continuously.

According to a further aspect, a multilayer circuit board may be produced by providing a flat first dielectric layer and a flat second dielectric layer. Each of the first and second dielectric layer may have a first side and a second side. A first conductor path may be arranged on the first side of the first dielectric layer, and a second conductor path on the first side of the second conductive layer. The first dielectric layer and the second dielectric layer may be arranged relative to one another such that the first side of the second dielectric layer faces towards the first side of the first dielectric layer. Between the first conductor path and the second conductor path an electrical connection may be formed by means of induction soldering.

### BRIEF DESCRIPTION OF THE DRAWINGS

The invention can be better understood with reference to the following drawings and description. The components in the figures are not necessarily to scale, instead emphasis being placed upon illustrating the principles of the invention. Moreover, in the figures like reference numerals designate identical or equivalent parts. In the drawings:
FIG. 1 is a cross-sectional view of a conventional multilayer circuit board comprising a via which establishes an electrical connection between two interior electric layers.
FIGS. 2 to 4 illustrate different steps of a method for producing an improved multilayer circuit board.
FIG. 5 illustrates a section of an improved multilayer circuit board in which the exterior electric layers are equipped with further electric components in the area of an electrical connection between two interior electric layers.
FIG. 6 is a perspective view of the electric layers of an improved multilayer circuit board.
FIG. 7 is a perspective view of a lens adjusting unit comprising an improved multilayer circuit board and a lens mechanically joined therewith.

### DETAILED DESCRIPTION OF THE DRAWINGS

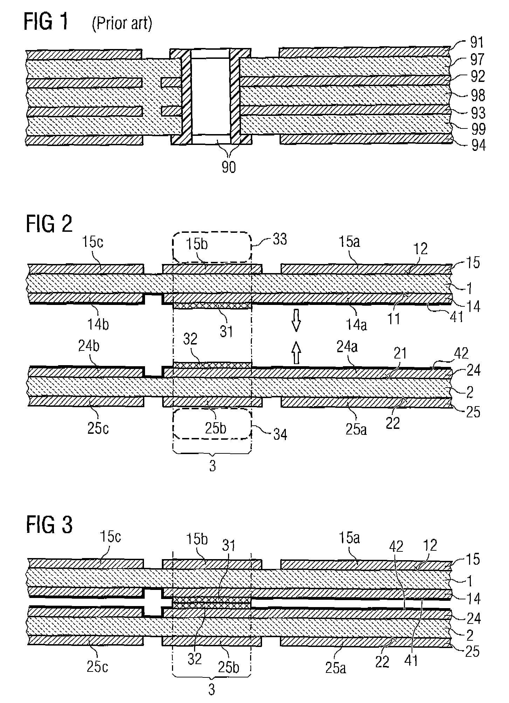

FIG. 1 shows a conventional multilayer circuit board comprising four electric layers 91, 92, 93, 94. Between adjacent electric layers 91, 92, 93, 94, dielectric layers 97, 98, 99 are arranged. The electric layers 91 and 94 are the outermost of the electric layers 91, 92, 93 and 94 and therefore designated as exterior electric layers 91 and 94, respectively. Accordingly, the electric layers 92 and 93 are arranged between the exterior electric layers 91 and 94 and therefore designated as interior electric layers 92 and 93, respectively.

In order to electrically connect two interior electric layers 92 and 93, the circuit board comprises a via 90 which requires a through hole being produced in the multilayer board. However, such a via 90 wastes space not only in the level of the interior layers 92 and 93 but also in the level of the exterior layers 91 and 94. Further, the via 90 causes an increased weight of the multilayer board. This may be disadvantageous in applications in which the multilayer board needs to be moved, in particular accelerated and/or decelerated.

FIG. 2 shows a flat first dielectric layer 1 having a first side 11 and a second side 12, and a flat second dielectric layer 2 having a first side 21 and a second side 22. The first side 21 of the second dielectric layer 2 faces towards the first side 11 of the first dielectric layer 1. On the first side 11 of the first dielectric layer 1 a first conductor path 14a is arranged. Accordingly, a second conductor path 24a is arranged on the first side 21 of the second dielectric layer 2.

The first conductor path 14a is formed in an interior metallization layer 14 which is arranged on the first side 11 of the first dielectric layer 1. The second conductor path 24a is formed in an interior metallization layer 24 which is arranged on the first side 21 of the second dielectric layer 2. In the sense of the present invention, each metallization layer 14, 24 which is arranged between the outermost metallization layers 15 and 25 is designated as interior metallization layer. Generally, an improved multilayer circuit board may also comprise more than two interior metallization layers 14, 24. The dielectric layers 1, 2 may be stiff plates, or - in order to form a flexible multilayer circuit board - flexible foils.

In addition to the first conductor path 14a and/or the second conductor path 24a, the respective metallization layers 14 and 24, respectively, may optionally comprise one or more additional conductor paths 14b and 24b, respectively. Moreover, an optional metallization layer 15 may be arranged on the second side 12 of the first dielectric layer 1, and/or an optional metallization layer 25 may be arranged on the second side 22 of the second dielectric layer 2. Such an optional metallization layer 12, 25 may be formed continuously, or - as shown in FIG. 2 - comprise two or more conductive paths 15a, 15b, 15c and 25a, 25b, 25c, respectively.

In order to form an electrical connection between the first conductor path 14a and the second conductor path 24a, the first dielectric layer 1 and the second dielectric layer 2 are arranged relative to one another such that the first side 21 of the second dielectric layer 2 faces towards the first side 11 of the first dielectric layer 1. In a predefined lateral area 3 in which the electrical connection is to be produced, a solder 31, 32 is arranged between the first conductor path 14a and the second conductor path 24a. For example, onto one or - as shown in FIGS. 2 and 3 - onto both of the first conductor path 14a and the second conductor path 24a to be connected a solder 31 and/or 32 may be applied in the predefined lateral area 3. In the sense of the present application, the predefined lateral area 3 comprises the sections of the first and second conductor path 14a and 24a, respectively, in which the first and second conductor path 14a and 24a, respectively, are to be electrically connected by soldering. The predefined lateral area 3 also comprises spatial areas 33 on the second side 12 of the first dielectric layer 1 and 34 on the second side 22 oft the second dielectric layer 2, i.e. the spatial areas 33 and 34 are located on the side of the respective dielectric layer 1 and 2, respectively, opposite the area in which an electrical connection between the first and second conductor path 14a and 24a is to be produced.

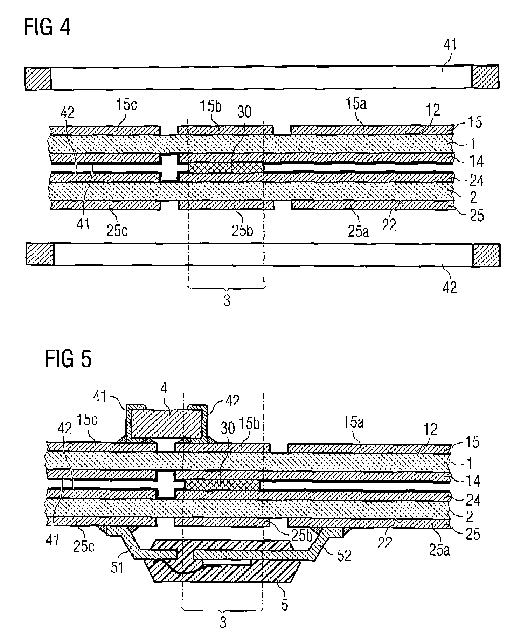

Then, as shown in FIG. 4, the solder 31 and/or 32 is melted by means of induction soldering such that a joint formed of solder 30 extends continuously from the first conductor path 14a to the second conductor path 24a. The joint of solder 30 comprises the solder 31 and/or 32. The induction soldering takes place by arranging the predefined lateral area 3 and the solder 31 and/or 32 in the sphere of an alternating electromagnetic field generated by at least one induction coil being supplied with an alternating electrical current. During the soldering process, the first dielectric layer 1 and the second dielectric layer 2 may be pressed against one another so as to allow a solder 31 arranged on the first conductor path 14a to make contact with the second conductor path 24a or a solder 32 arranged thereon, and/or to allow a solder 32 arranged on the second conductor path 24a to make contact with the first conductor path 14a or a solder 31 arranged thereon.

Exemplary, in FIG. 4 the predefined lateral area 3 and the solder 31, 32 are arranged between two induction coils 41 and 42. The induction coils 41 and 42 are electrically coupled (not shown in detail) in order to generate a homogeneous alternating electromagnetic field. However, it may be sufficient to use only one instead of two induction coils 41, 42.

As shown in FIG. 5, the first and/or second dielectric layer 1 and 2, respectively, may be formed continuously in the predefined lateral area 3 of the soldered joint. As there is no via required for forming the electrical connection between the first conductor path 14a and the second conductor path 24a, the space in the predefined lateral area 3 on the second side 12 of the first dielectric layer 1 and on the second side 22 of the second dielectric layer 2 is not waste and may be used for mounting, e.g., electrical or other components 4, 5, on the multilayer circuit board, i.e. in the predefined lateral area 3 of the solder joint at least a part of a first component 4 may be mounted to the second side 12 of the first dielectric layer 1 and/or at least a part of a second component 5 may be mounted to the second side 22 of the second dielectric layer 2. As an example, the component 4 is an SMD resistor having leads 41 and 42 which are soldered to conductive paths 15c and 15b, respectively, formed in the metallization layer 15, and the component 5 is a semiconductor circuit having leads 51 and 52 which are soldered to conductive paths 25c and 25a, respectively, formed in the metallization layer 25. Of course, the spatial areas 33 and/or 34 shown in FIG. 2 may remain free of any components.

In order to precisely define the location of the soldered connection 30, on at least one of (interior) metal layers 14, 15, a dielectric films 41 and 42 (see FIGS. 2 to 5), respectively, may be produced on the opposite side of the respective dielectric layer 1 and 2. Then, the dielectric films 41, 42 may be opened in the predefined lateral area 3, and a solder 31, 32 may be applied onto the first conductive path 14a and/or onto the second conductive path 24a in the area of the openings. Due to the dielectric films 41, 42, unintentional short circuits to and between adjacent conductor paths 14b, 24b caused by deliquescing solder 31, 32 is avoided.

Alternative to openings produced in a continuous dielectric film 41, 42, the dielectric films 41 and/or 42 may be applied onto the first conductive path 14a and/or onto the second conductive path 24a selectively on that surface areas of the metallizations 14 and 24, respectively, only which shall remain sealed by the respective film 41, 42. For example, the material of the dielectric film 41, 42 may be printed onto the respective conductive path 14a, 24a in the same manner as an inkjet printer prints color onto a sheet of paper. In particular, a dielectric film 41, 42 may be a layer of protective lacquer.

Generally, an improved multilayer circuit board may also comprise two or more such interior soldered connections 30 between arbitrary interior metallization layers. In that case, two or more soldered connections 30 may be induction soldered in the same soldering step at the same time, i.e. in the same electromagnetic field generated by the at least one induction coil 41, 42.

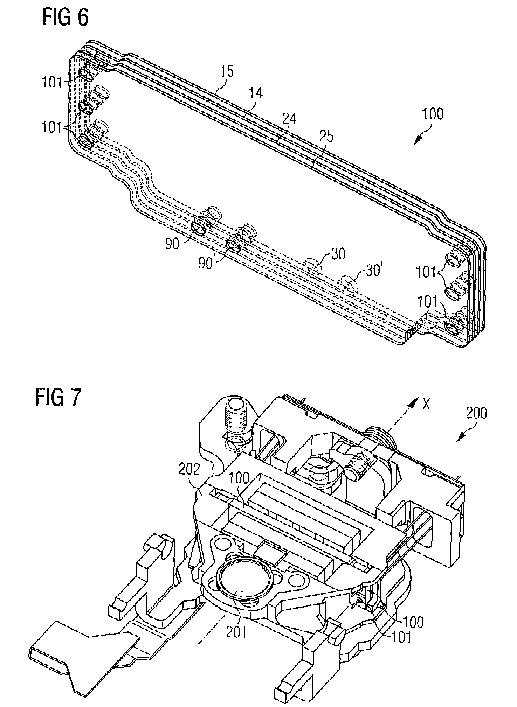

FIG. 6 is a perspective view showing the metallization layers 15, 14, 24 and 25 of an improved multilayer circuit board 100 only. In that view, the (existing) intermediate dielectric layers are suppressed. The board 100 comprises soldered interior joints 30, 30' which have been produced as described above with reference to FIGS. 2 to 5. In FIG. 6, the soldered joints 30, 30' are shaded grey as in fact they are covered by the exterior metallization layer 25 and therefore invisible.

Additionally, the board 100 may also comprise one or more conventional vias 90, 90' such as the via 90 explained with reference to FIG. 1. Further, the board 100 may comprise one or more assembly openings 101 which extend through the board 100 and which may serve for mounting the board 100.

FIG. 7 is a perspective view of a lens adjusting unit comprising an improved multilayer circuit board 100 and a lens 201. The lens 201 is mechanically joined with the board 100 by use of a mounting frame 202. At least two interior metallizations of the board comprise a turn of a coil. Each of the turns is formed as conductive path which is formed by structurizing the respective interior metallization. In order to produce a coil having two or more turns, the turns formed in adjacent metallizations have been electrically connected by electrical joints such as the joint 30 described with reference to FIGS. 2 to 7. In particular, the board 100 may be a board as described with reference to FIG. 6. The coil is positioned in a magnetic field of a permanent magnet or of an electromagnet. By supplying a defined electric current to the coil, the board 100 together with the mounting frame 202 and the lens 201 may be moved back and forth in a direction x which may run substantially perpendicular to the board 100.

Due to the absence or the reduced number of conventional vias in the board 100, the weight and therefore the inertial mass of the board 100 are reduced, i.e. the time required for adjusting the lens 201 together with the board 100 and the mounting frame 202 is also reduced.

Generally, an improved multilayer circuit board may be used in other technical fields, e.g. in mobile computers, mobile phones, portable audio players, in optical scanner units, in optical drives, in mobile navigation systems, in personal data assistants etc.

While various embodiments of the invention have been described, it will be apparent to those of ordinary skill in the art that other embodiments and implementations are possible that are within the scope of this invention. Accordingly, the invention is not restricted except in light of the attached claims and their equivalents.

## Claims

1. A multilayer circuit board comprising
a flat first dielectric layer having a first side and a second side;
a flat second dielectric layer having a first side and a second side, the first side of the second dielectric layer facing towards the first side of the first dielectric layer;
a first conductor path which is arranged on the first side of the first dielectric layer;
a second conductor path which is arranged on the first side of the second dielectric layer; and
a soldered joint which is arranged between the first dielectric layer and the second dielectric layer, and which electrically connects the first conductor path and the second conductor path;
where the first dielectric layer is formed continuously in the area of the soldered joint.

2. The multilayer circuit board of claim 1, where the second dielectric layer is formed continuously in the area of the soldered joint.

3. The multilayer circuit board of one of claims 1 or 2, where the first conductor path and the second conductor path form an electric coil.

4. The multilayer circuit board of one of the preceding claims, where a solder extends continuously from the first conductor path to the second conductor path within the area of the soldered joint.

5. The multilayer circuit board of one of the preceding claims, where
in the area of the solder joint at least a part of a first electric component is mounted to the second side of the first dielectric layer; and/or
at least a part of a second electric component is mounted to the second side of the second dielectric layer.

6. The multilayer circuit board of one of the preceding claims, where a first metallization is arranged on the second side of the first dielectric layer;

7. The multilayer circuit board of one of the preceding claims which is mechanically joined with a lens.

8. A method for producing a multilayer circuit board comprising the steps:
providing a flat first dielectric layer having a first side and a second side , and a first conductor path arranged on its first side;
providing a flat second dielectric layer having a first side and a second side, and a second conductor path arranged on its first side;
arranging the first dielectric layer and the second dielectric layer relative to one another such that the first side of the second dielectric layer faces towards the first side of the first dielectric layer; and
forming an electrical connection between the first conductor path and the second conductor path by means of induction soldering.

9. The method of claim 8, where
prior to the step of induction soldering, a first surface section is predefined on the first conductive line, and a second surface section is predefined on the second conductive line; and where
the electrical connection is formed between the first surface section and the second surface section.

10. The method of claim 9, where, prior to the step of induction soldering, the first surface section and the second surface section are arranged opposite to one another.

11. The method of claim 9 or 10, where, prior to the step of induction soldering, a solder is arranged between the first surface section and the second surface section.

12. The method of one of claims 9 to 11, where, prior to the step of induction soldering, to one or to both of the first surface section and the second surface section a solder is applied.

13. The method of claim 12, where the solder is fused during the step of induction soldering.

14. The method of one of claims 8 to 13, where the first dielectric layer and/or the second dielectric layer is formed continuously in the area of the electrical connection.

15. The method of one of claims 8 to 14, where in the area of the solder joint
at least a part of a first electric component is mounted to the second side of the first dielectric layer; and/or
at least a part of a second electric component is mounted to the second side of the second dielectric layer.

## Amended claims

### Amended claims in accordance with Rule 137(2) EPC.

**1.** A multilayer circuit board comprising
a flat first dielectric layer (1) having a first side (11) and a second side (12);
a flat second dielectric layer (2) having a first side (21) and a second side (22), the first side (21) of the second dielectric layer (2) facing towards the first side (11) of the first dielectric layer (1);
a first conductor path (14a) which is arranged on the first side (11) of the first dielectric layer (1);
a second conductor path (24a) which is arranged on the first side (21) of the second dielectric layer (2); and
a soldered joint which is arranged between the first dielectric layer (1) and the second dielectric layer (2), and which electrically connects the first conductor path (14) and the second conductor path (24);
where the first dielectric layer (1) is formed continuously in the area (3) of the soldered joint,
**characterized in that**
the first conductor path (14a) and the second conductor path (24a) form an electric coil.

**2.** The multilayer circuit board of claim 1, where the second dielectric layer (2) is formed continuously in the area (3) of the soldered joint.

**3.** The multilayer circuit board of one of the preceding claims, where a solder (30) extends continuously from the first conductor path (14a) to the second conductor path (24a) within the area (3) of the soldered joint.

**4.** The multilayer circuit board of one of the preceding claims, where in the area (3) of the solder joint
at least a part of a first electric component (4) is mounted to the second side (12) of the first dielectric layer (1); and/or
at least a part of a second electric component (5) is mounted to the second side (22) of the second dielectric layer (2).

**5.** The multilayer circuit board of one of the preceding claims, where a first metallization (15) is arranged on the second side (12) of the first dielectric layer (1);

**6.** The multilayer circuit board of one of the preceding claims which is mechanically joined with a lens (201).

**7.** A method for producing a multilayer circuit board (100) comprising the steps:
providing a flat first dielectric layer (1) having a first side (11) and a second side (12), and a first conductor path (14a) arranged on its first side (11);
providing a flat second dielectric layer (2) having a first side (21) and a second side (22), and a second conductor path (24a) arranged on its first side (21);
arranging the first dielectric layer (1) and the second dielectric layer (2) relative to one another such that the first side (21) of the second dielectric layer (2) faces towards the first side (11) of the first dielectric layer (1); and
forming an electrical connection between the first conductor path (14a) and the second conductor path (24a) by means of induction soldering,
**characterized in that**
an electric coil is formed from the first conductor path (14a) and the second conductor path (24a).

**8.** The method of claim 7, where
prior to the step of induction soldering, a first surface section is predefined on the first conductive line (14a), and a second surface section is predefined on the second conductive line (24a); and where
the electrical connection is formed between the first surface section and the second surface section.

**9.** The method of claim 8, where, prior to the step of induction soldering, the first surface section and the second surface section are arranged opposite to one another.

**10.** The method of claim 8 or 9, where, prior to the step of induction soldering, a solder (31, 32) is arranged between the first surface section and the second surface section.

**11.** The method of one of claims 8 to 10, where, prior to the step of induction soldering, to one or to both of the first surface section and the second surface section a solder (31, 32) is applied.

**12.** The method of claim 11, where the solder (31, 32) is fused during the step of induction soldering.

**13.** The method of one of claims 7 to 12, where the first dielectric layer (1) and/or the second dielectric layer (2) is formed continuously in the area (3) of the electrical connection.

**14.** The method of one of claims 7 to 13, where in the area (3) of the solder joint
at least a part of a first electric component (4) is mounted to the second side (12) of the first dielectric layer (1); and/or
at least a part of a second electric component (5) is mounted to the second side (22) of the second dielectric layer (2).
